# EUROPÄISCHE PATENTSCHRIFT

(11) **EP 3 900 857 B1**
(45) Veröffentlichungstag und Bekanntmachung des Hinweises auf die Patenterteilung: **07.08.2024**
(21) Anmeldenummer: 20170681.9
(22) Anmeldetag: 21.04.2020
(51) Int. Cl.: B22F 10/28, B33Y 10/00, B33Y 50/02, G01J 3/433, G01N 21/71, G01N 23/22, G01N 25/00, G06F 30/27, G06N 3/08, G06N 20/00, G06N 5/00, G06N 7/00, G06N 20/10, G06N 20/20, B23K 26/34, B22F 10/36, B22F 10/85, G06N 5/01, G06N 7/01

(54) **ERMITTELN EINER STRAHLUNGSINTENSITÄT UND/ODER EINER WELLENLÄNGE EINES PROZESSLEUCHTENS**
DETERMINATION OF A RADIATION INTENSITY AND / OR A WAVELENGTH OF A PROCESS LIGHT
DÉTECTION D'UNE INTENSITÉ DE RAYONNEMENT ET/OU D'UNE LONGUEUR D'ONDE D'UNE LUMIÈRE DE TRAITEMENT

(43) Veröffentlichungstag der Anmeldung: 27.10.2021
(73) Patentinhaber: Siemens Aktiengesellschaft, 80333 München (DE)
(72) Erfinder: Heinrichsdorff, Frank, 14513 Teltow (DE)
(74) Vertreter: Siemens Patent Attorneys

(56) Entgegenhaltungen:
- EP-A1- 3 650 143
- LUKE SCIME ET AL: "Using machine learning to identify in-situ melt pool signatures indicative of flaw formation in a laser powder bed fusion additive manufacturing process", ADDITIVE MANUFACTURING, vol. 25, 1 January 2019 (2019-01-01), NL, pages 151 - 165, XP055740072, ISSN: 2214-8604, DOI: 10.1016/j.addma.2018.11.010
- LINGBIN MENG ET AL: "Machine Learning in Additive Manufacturing: A Review", JOM: JOURNAL OF METALS, vol. 72, no. 6, 17 April 2020 (2020-04-17), United States, pages 2363 - 2377, XP055709376, ISSN: 1047-4838, DOI: 10.1007/s11837-020-04155-y
- GONZALEZ-VAL CARLOS ET AL: "A convolutional approach to quality monitoring for laser manufacturing", JOURNAL OF INTELLIGENT MANUFACTURING, CHAPMAN AND HALL, LONDON, GB, vol. 31, no. 3, 9 October 2019 (2019-10-09), pages 789 - 795, XP037043815, ISSN: 0956-5515, [retrieved on 20191009], DOI: 10.1007/S10845-019-01495-8
- YIM SUNGSHIK ET AL: "A Framework for Self-Realizing Process Models for Additive Manufacturing", PROCEEDINGS OF THE ASME INTERNATIONAL DESIGN ENGINEERING TECHNICAL CONFERENCES AND COMPUTERS AND INFORMATION IN ENGINEERING CONFERENCE - 2011 : PRESENTED AT ASME 2011 INTERNATIONAL DESIGN ENGINEERING TECHNICAL CONFERENCES AND COMPUTERS AND INFORMATIO, 1 January 2011 (2011-01-01), US, pages 1099 - 1109, XP055840728, ISBN: 978-0-7918-5479-2, Retrieved from the Internet <URL:http://dx.doi.org/10.1115/DETC2011-47425> DOI: 10.1115/DETC2011-47425

## Beschreibung

Die Erfindung betrifft ein Verfahren zum Ermitteln von Prozessabweichungen eines Schmelzprozesses umfassend ein Verfahren zum Ermitteln einer Strahlungsintensität und/oder einer Wellenlänge eines Prozessleuchtens..

In Pulverbett-basierten AM Anlagen wird zunehmend die Erfassung von Prozessleuchten (Emission im sichtbaren und nahen Infrarot) zum Prozessmonitoring durchgeführt. Hierfür werden koaxiale Sensoren (z. B: "Meltpool-Monitoring" via Photodioden) oder am Bauraum montierte ortsaufgelöste (Kameras) oder integrierende Sensoren (Photodioden, Pyrometer) eingesetzt. Da kein vorab bekannter Sollwert für die ortsabhängige Emission existiert (dieser müsste sowohl von den Prozessparametern als auch von der belichteten Geometrie abhängen}, kann als Indikator für eine Prozessauffälligkeit eine Abweichung der detektierten Intensität von einem Mittelwert um einen statistisch ermittelten Betrag (z.B. 1 x Sigma, 3 x Sigma) verwendet werden. Das bedeutet, dass die Detektionsgrenze durch die statistische und systematische Varianz des Signals definiert wird. In der Praxis wird es damit schwierig, Prozessabweichungen sicher zu erkennen. GONZALEZ-VAL CARLOS ET AL: "A convolutional approach to quality monitoring for laser manufacturing", JOURNAL OF INTELLIGENT MANUFACTURING, CHAPMAN AND HALL, LONDON, GB, Bd. 31, Nr. 3, 9. Oktober 2019 (2019-10-09), Seiten 789-795 beschäftig sich zwar mit einem Verfahren zur Live-Überwachung von laserbasierten Herstellungsprozessen. Auch der Einsatz eines neuralen Netzes zur Modellierung von Prozesseigenschaften und Qualitätsmerkmalen wird darin beschrieben. Das Verfahren hat jedoch den Nachteil nur unzureichender Genauigkeit bei der Leistungsermittlung.

Es ist Aufgabe der Erfindung die Ermittlung von Prozessabweichungen bei einem Schmelzprozess zu verbessern. Es ist weiterhin Aufgabe der Erfindung die Ermittlung einer Strahlungsintensität und/oder einer Wellenlänge eines Prozessleuchtens des Schmelzprozesses zu verbessern.

Zum Lösen dieser Aufgabe wird ein Verfahren zum Ermitteln von Prozessabweichungen eines Schmelzprozesses beim Erzeugen eines Werkstücks oder beim Fügen von Werkstücken angegeben. Das erfindungsgemäße Verfahren ist durch den beigefügten unabhängigen Anspruch definiert. Das Verfahren umfasst dabei die folgenden Schritte: Bereitstellen eines Sollwerts für ein Prozessleuchten eines Schmelzbads, Erfassen einer vom Schmelzbad emittierten Strahlungsintensität und/oder einer Wellenlänge des Prozessleuchtens als Istwert und Vergleichen des Sollwerts mit dem Istwert, um Prozessabweichungen zu detektieren.

Der Sollwert für ein Prozessleuchten eines Schmelzbads wird durch ein Ermittlungsverfahren einer Strahlungsintensität und/oder Wellenlänge des Prozessleuchtens festgelegt. Eine vom Schmelzbad imitierte Strahlungsintensität und/oder eine Wellenlänge des Prozessleuchtens wird als ein Istwert erfasst, also z. B. gemessen. Der Sollwert wird mit dem Istwert verglichen, um Prozessabweichungen zu ermitteln. Die Prozessabweichungen sind dabei ein Maß für die Qualität des Prozesses und können in einem weiteren Schritt für eine Regelung des Prozesses verwendet werden. Besonders vorteilhaft hat sich erwiesen, dass als Sollwert ein besonders genauer gemäß dem erfindungsgemäßen Verfahren ermittelter Wert der Strahlungsintensität und/oder der Wellenlänge des Prozessleuchtens, wobei das Prozessleuchten Emission im sichtbaren und nahen Infrarotbereich umfasst, verwendet wird. Im Vergleich zur Verwendung einer Abweichung als Indikator für eine Prozessauffälligkeit, z.B. eine Abweichung der detektierten Intensität von einem Mittelwert um einen statistisch ermittelten (z. B. einmal Sigma oder dreimal Sigma) stellt der erfindungsgemäß ermittelte Wert als Sollwert eine erhebliche Verbesserung dar.

Das dem Prozessleuchten zugrunde liegende Schmelzbad wird durch ein Bestrahlen eines metallischen Werkstoffs mit einem Energiestrahl entlang wenigstens eines Weges erzeugt. Der Energiestrahl, wobei der Energiestrahl ein Laserstrahl ist, ist dabei gemäß einem Leistungsprofil entlang des Weges bewegbar. Das Ermittlungsverfahren einer Strahlungsintensität und/oder einer Wellenlänge eines Prozessleuchtens umfasst dabei folgende Schritte: Bereitstellen des Leistungsprofils für einen Abschnitt des Weges als eine Eingangsgröße für ein Modell des maschinellen Lernens. Das Modell des maschinellen Lernens ist dabei insbesondere als ein neuronales Netz ausgebildet und wird dabei im Englischen als "Machine Learning Model" bezeichnet. Das Modell ist dabei mit historischen Leistungsprofilen und dem dazugehörigen historischen Strahlungsintensitäten und/oder Wellenlängen des Prozessleuchtens trainiert. Das Modell (MLM) weist eine Topologie mit Regressionskoeffizienten auf. In einem weiteren Schritt wird die Strahlungsintensität und/oder die Wellenlänge des Prozessleuchtens nun durch das Modell des Maschinellen Lernens als Ausgangsgröße des Modells ermittelt.

Das Schmelzbad kann sich dabei z. B. in einem Pulverbett, auf einem Substrat oder in einem Pulverbett, das auf einem Substrat angeordnet ist, befinden. Insbesondere befindet sich die Schmelzzone in einem Pulverbett, das selektiv und Schicht für Schicht eingeschmolzen wird, um ein Werkstück zu erzeugen. Bei Schweißverbindungen kann sich die Schmelzzone analog zwischen zwei oder mehreren zu fügenden Werkstücken ausbilden.

Als Modelle des maschinellen Lernens kommen insbesondere Modelle für überwachtes Lernen (engl: supervised learning) bzw. teilüberwachtes Lernen zum Einsatz, da die Eingangsgrößen und Ausgangsgrößen zum großen Teil gut erfassbar oder approximierbar sind. Insbesondere die Energiestrahlleistung (also z.B: die an einem Laser einer SLM-Anlage eingestellte Leistung) lässt sich hier in Verbindung mit weiteren Prozessparametern, wie Strahlgeschwindigkeit und Strahlpfade, die oft in sogenannten Belichtungsvektoren zusammengefasst werden, gut erfassen. Als besonders vorteilhafte Ausgestaltungen der Modelle des maschinellen Lernens haben sich im vorliegenden Fall neuronale Netze, Support Vektor Maschinen, sowie Random Forest Modelle (allg.: Entscheidungsbäume) herausgestellt. Das ML-Modell zur Vorhersage des Prozessleuchtens wird hierbei als Regressor, und nicht zur Klassifikation verwendet.

Allerdings sind Kombinationen verschiedener ML-Modelle - z. B. ein Modell zum Ermitteln des Prozessleuchtens und ein Modell zur Klassifikation der Abweichung des Prozessleuchtens vom Sollwert möglich.

Das Leistungsprofil beschreibt die Leistung des Energiestrahls, im Abschnitt des Weges eingebracht wurde. Dabei kann eine Position gewählt werden, an der das Prozessleuchten ermittelt werden soll. Dabei kann die Position Teil des Abschnitts sein. Der Abschnitt kann sich ebenso über die Position erstrecken, z. B. indem geplante Sollwerte die auf die Position folgen verwendet werden.

Das Leistungsprofil ist aus der eingestellten Energiestrahlleistung, also z. B. der Laserleistung, ermittelbar. Auf diese Weise kann einfach und mit hinreichender Genauigkeit, z. B. unter Berücksichtigung eines Reflexionsanteils des Energiestrahls am Werkstoff, die auf den Werkstoff eingestrahlte und schließlich absorbierte Leistung ermittelt werden.

Die historischen Leistungsprofile und die dazugehörigen historischen Strahlungsintensitäten und/oder Wellenlängen sind dabei aus vorhergehenden Messreihen zur Verfügung gestellt. Es ist ebenso denkbar, dass für einfache Fälle modellbasiert Leistungsprofile mit einem modellbasierten Ansatz in dazugehörige synthetische Strahlungsintensitäten und/oder Wellenlängen umgesetzt werden, die dann wiederum zum Training des Modells verwendet werden. Es hat sich herausgestellt, dass ein mit realen Daten trainiertes Modell des maschinellen Lernens, z. B. ein neuronales Netz, eine hohe Ermittlungsqualität bezüglich des Prozessleuchtens erreicht. Das trainierte Modell kann dabei im Gegensatz zu einem Simulationsmodell einen deutlichen Rechenzeitvorteil erreichen. Ebenso können existierende Nichtlinearitäten mit einem trainierten Modell des maschinellen Lernens effizienter abgebildet werden.

In einer weiteren Ausführungsform umfasst das Verfahren weiterhin den Schritt des Bereitstellens zumindest einer Abstandshistorie für den Abschnitt als Eingangsgröße für das Modell. Die Abstandshistorie beschreibt dabei den Abstand zwischen dem jeweiligen Datenpunkt auf dem Abschnitt und der Position, an der die Strahlungsintensität und/oder die Wellenlänge des Prozessleuchtens ermittelt werden soll. Die Abstandshistorie ist als Funktion der Zeit ausgebildet, alternativ könnte die Abstandshistorie auch als Abstands-Transiente bezeichnet werden. So kann besser abgeschätzt werden, wie das Leistungsprofil auf das jeweilige Schmelzbad einwirkt, da so der Abstand als Gewichtungsfaktor mit einfließen kann.

In einer weiteren Ausführungsform umfasst das Verfahren den Schritt des Bereitstellens zumindest eines Massenprofils für den Abschnitt als Eingangsgröße für das Modell. Das Massenprofil beschreibt dabei die zugrunde liegende Masse für jeden Datenpunkt des Leistungsprofils, um eine höhere Genauigkeit der Erwärmung des Schmelzbads und der damit einhergehenden Veränderung des Prozessleuchtens zu erreichen. Auch das Massenprofil kann als Funktion der Zeit angegeben werden.

In einer weiteren Ausführungsform wird eine Hintergrundtemperatur als Eingangsgröße für das Modell zur Verfügung gestellt. Die Hintergrundtemperatur ist dabei die Temperatur, die als Basisniveau für das Modell dient. In anderen Worten ist die Hintergrundtemperatur die Temperatur, die der Werkstoff bzw. das Werkstück aufweist. Die Genauigkeit des Verfahrens kann durch Verwenden einer Hintergrundtemperatur erhöht werden. Es ist denkbar, dass die Hintergrundtemperatur einer einfachen Kurve folgt oder einen gemittelten Wert annimmt.

Die Hintergrundtemperatur kann dabei aber ebenso aus einer übergeordneten Simulation stammen, die auf Basis eines thermischen CAD Modells des zu fertigenden Werkstücks bzw. der herzustellenden Schweißnaht durchgeführt werden kann. Weiterhin kann die Hintergrundtemperatur für gewisse Werkstücke in abhängig von der Bestrahlungsdauer und von einer vorhergehenden Temperatur bereitgestellt werden.

Das Modell des maschinellen Lernens weist eine Topologie mit Regresskoeffizienten (auch Regressionsparameter oder Regressionsgewichte) auf. Es hat sich herausgestellt, dass eine Topologie mit Regressionskoeffizienten sehr gute Ergebnisse bei der Abbildung des Prozessleuchtens liefert. Insbesondere können mehrlagige Neuronale Netze mit den typischerweise verwendeten nichtlinearen Aktivierungsfunktion oder tiefe Entscheidungsbäume auch komplexe Abhängigkeiten der Ausgangsgröße (Prozessleuchten) von den relevanten Merkmalen (Leistungshistorie, Geometrie, ...) ausreichend annähern.

In einer weiteren Ausführungsform wird ein für den Abschnitt repräsentatives Volumenelement als Eingangsgröße für das Modell zur Verfügung gestellt. Das Volumenelement kann dabei aus einem sogenannten Jobfile oder einem speziellen Konturfile extrahiert werden. Dabei kann es sich beispielsweise um sogenannte Scheiben, also Slices handeln, deren Geometrie für den Abschnitt berücksichtigt werden. Das Volumenelement kann dabei auch dafür verwendet werden, eine repräsentative Masse zu ermitteln. In einer weiteren Ausführungsform ist es ebenso denkbar, dass eine für den Abschnitt repräsentative Werkstückgeometrie, insbesondere aus einer CAD-Datei, als Eingangsgröße für das Modell zur Verfügung gestellt. Anhand der Werkstückgeometrie, in der der Werkstoff verarbeitet wird, kann erkannt werden, ob sich hier eine kritische Geometrie befindet. Wird beispielsweise eine Verjüngung bearbeitet, so kann es sinnvoll sein, so lange die gesamte Verjüngung zu betrachten, bis das Schmelzbad einen hinreichend großen Abstand von der Verjüngung erreicht hat. Erst wenn der Abstand des Schmelzbads von der Verjüngung hinreichend groß ist, kann ausgeschlossen werden, dass das Material im Bereich der Verjüngung wieder einschmilzt. So wäre in diesem Fall eine dementsprechend großes repräsentatives Volumenelement zu wählen bzw. ein Volumenelement, dass solange der Abstand nicht groß genug ist, die Verjüngung, also eine Kritische Stelle, umfasst.

In einer weiteren Ausführungsform ist der Abschnitt so gewählt, dass zumindest eine Unterbrechung des Energiestrahls umfasst ist. Der Energiestrahl wird in sogenannten Belichtungsvektoren über das Werkstück bzw. über den Werkstoff geführt. Um von einem Vektor zum anderen zu wechseln, werden sogenannte Skywriting-Zeiten eingeplant. Das heißt der Energiestrahl wird deaktiviert, die Positionsmechanismen, also beispielsweise die Spiegel, positionieren neu und der Energiestrahl wird am Anfang des nächsten Vektors bzw. der nächsten Belichtungsspur wieder aktiviert. Da diese Spuren nebeneinander liegen, hat es sich als besonders vorteilhaft erwiesen, mehrere dieser Spuren zu betrachten, weswegen eine Auswahl des Abschnitts im Idealfall mindestens eine Unterbrechung des Energiestrahls oder mehrere Unterbrechungen des Energiestrahls umfasst.

In einer weiteren Ausführungsform wird der Abschnitt abhängig von einer weiteren Werkstückgeometrie gewählt. Die Länge des Abschnitts kann dabei je nach Komplexität der Werkstückgeometrie variiert werden. Dabei können beispielsweise benachbarte Belichtungsvektoren in den Abschnitt einbezogen werden. Belichtungsvektoren umfassen dabei die Koordinaten in denen der Energiestrahl über den Werkstoff geführt wird. Weiterhin umfasst der Belichtungsvektoren die Strahlleistung und die Geschwindigkeit mit der die Koordinaten abgefahren werden.

In einer weiteren Ausführungsform wird die Relevanz der Prozessabweichung anhand von Klassifikationsparametern gewichtet. Zu den Klassifikationsparametern können beispielsweise die Ausdehnung, die Fläche oder das Volumen der betroffenen Gebiete dienen, um eine angemessene Reaktion auf die Prozessabweichung zu ermitteln. So kann ein Gebiet mit einer hohen Masse und einer festen Struktur eine andere Art von Prozessabweichungen überstehen, wie ein filigranes Gebiet, in dem sich viele feine Strukturen im Bereich des Schmelzbads befinden.

In anderen Worten lässt sich ein Verfahren zur Detektion von Prozessauffälligkeiten bzw. -abweichungen zwei Schritte gliedern:
1. Eine Detektion auffälliger Gebiete mittels einem Soll-Ist-Vergleich wie beschrieben.
2. Überprüfung der Relevanz der Abweichungen/Auffälligkeiten anhand von z.B. geometrischen Merkmalen wie Ausdehnung, Fläche oder Volumen, ggf. auch unter Verwendung einer Klassifikation der Abweichung bzw. des betreffenden Gebietes. Wird nun ein gemäß der Erfindung ermittelter Wert für das Prozessleuchten zur Ermittlung von Prozessauffälligkeiten verwendet und dadurch ein verbesserten Soll-Ist-Vergleich erreicht. Anstelle des Mittelwerts wird als Sollwert eine Ermittelter Wert für das Prozessleuchten genutzt. Hierfür wird aus gemessenen oder synthetischen Prozessdaten ein Modell des maschinellen Lernens trainiert, um eine von Prozessparametern und Geometrie abhängige Vorhersage des zu erwartenden Signals zu generieren. Als Eingangsparameter für die Vorhersage des Signals für einen Punkt der belichteten Fläche dient die eingestrahlte Energie der vorhergehenden Belichtungsvektoren in räumlicher und zeitlicher Nähe, sowie vorzugsweise ein aus der Geometrie abgeleitetes Massenintegral. Gegenüber der Verwendung eines Mittelwertes als Sollwert entsteht damit eine kleinere Varianz der Soll-Ist-Differenz, und die Detektionsgrenzen können enger gesetzt werden, womit die Sicherheit der Prozessfehlererkennung verbessert wird.

Weiterhin wird ein Verfahren zum Regeln eines Schmelzprozesses angegeben. Dabei wird eine wie obenstehend ermittelte Prozessabweichung verringert und/oder beseitigt, indem ein oder mehrere Prozessparameter, insbesondere eine Strahlleistung, eine Strahlgeschwindigkeit oder ein Abstand zwischen einzelnen Belichtungsvektoren variiert wird.

Im Folgenden wird die Erfindung anhand der in den Figuren dargestellten Ausführungsbeispiele näher beschrieben und erläutert. Es zeigen:
- FIG 1: eine schematische Darstellung eines Werkstoffs und eines Energiestrahls,
- FIG 2: eine schematische Darstellung des Erstellens von Eingangsgrößen für ein Modell des maschinellen Lernens,
- FIG 3: ein Modell des maschinellen Lernens mit seinen Eingangsgrößen und
- FIG 4: eine Regelung eines Energiestrahls basiert auf den Ermittelten Werten für das Prozessleuchten.

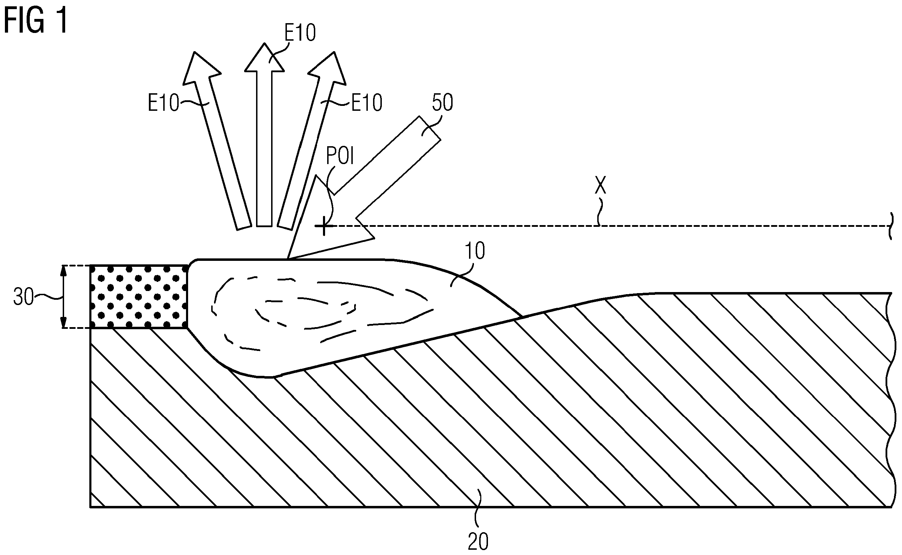

FIG 1 zeigt dabei eine schematische Darstellung eines Werkstoffs 20, auf dem ein pulverförmiger Werkstoff 30 aufgebracht ist. Ein Energiestrahl 50 erzeugt ein Schmelzbad 10, von dem ein Prozessleuchten E10 ausgeht. Der Energiestrahl 50 wird dabei entlang eines Weges x über den Werkstoff 20 geführt. Der Werkstoff 20 kann dabei Teil eines Werkstücks sein, das mittels eines additiven Fertigungsprozesses durch den Energiestrahl 50 gefertigt wird. Der Energiestrahl 50 weist dabei eine Strahlleistung auf, die in einem Leistungsprofil P über den Weg x geführt wird. Hier nicht zu sehen, da ein Querschnitt in der Ebene gezeigt ist, sind weitere durch den Weg x abgedeckte Belichtungsspuren oder Belichtungsvektoren, die parallel zu dem hier eingezeichneten Weg x in der Ebene liegen. Oberhalb des Schmelzbads 10 ist eine Position POI festgelegt, von der aus eine zeitliche Abstandshistorie d bezüglich weiterer Punkte auf dem Weg x definiert ist. Die Position POI kann dabei im Schmelzbad 10 liegen, ist hier aber der Übersichtlichkeit wegen etwas oberhalb eingezeichnet.

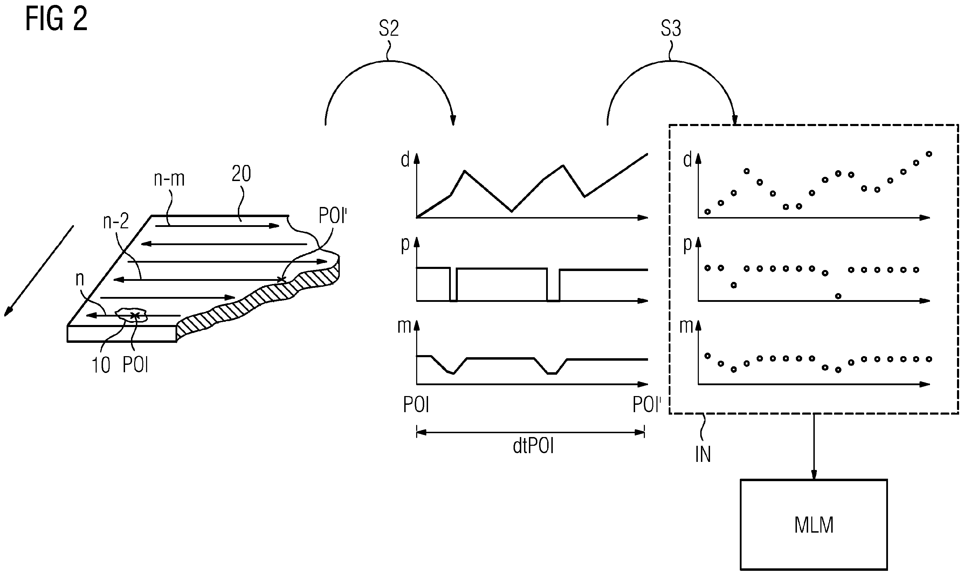

FIG 2 zeigt zunächst den aus FIG 1 bekannten Werkstoff 20, wobei diese in einer schrägen Ansicht gezeigt ist. Auf dem Werkstoff 20 sind Vektoren n bis n-m abgebildet, wobei die Vektoren n,..., n-m auf dem Weg x liegen, der hier der Übersichtlichkeit halber nicht eingezeichnet ist. Weiterhin zu sehen ist eine Position POI, die innerhalb des Schmelzbads 10 liegt. Weiterhin ist, um einen Abschnitt dtPOI zu bilden, der Beginn POI' des Abschnitts dtPOI eingezeichnet. Das Auswählen des Abschnitts dtPOI ist dabei ein erster Schritt S1. Der Abschnitt dtPOI liegt dabei vorzugsweise zeitbasiert vor. In einem zweiten Schritt S2 wird für den Abschnitt dtPOI eine lokale Historie vom Anfang POI' des Abschnitts dtPOI bis zur Position POI erzeugt. Diese lokale Historie umfasst in diesem Fall eine Abstandshistorie d, das den Abstand eines jeden Datenpunkts auf den Vektoren n, n-m bzw. auf dem Weg x zur Position POI beschreibt. Weiterhin wird ein Leistungsprofil erstellt, das die vom Energiestrahl 50 eingestrahlte Leistung beschreibt. Ein Massenprofil m beschreibt die am jeweiligen Datenpunkt zugrunde liegende Masse, die z.B. für ein Volumenelement und einer Integration darüber ermittelt werden kann. In einem Schritt S3 wird die erzeugte lokale Historie, also die Abstandshistorie d, das Leistungsprofil P und das Massenprofil m diskretisiert bzw. integriert. Dies wird vorteilhafterweise auf einem festen und ggf. nicht äquidistanten Raster durchgeführt. Die nun diskretisiert vorliegenden Daten können somit als Eingangsgrößen IN für ein Modell des maschinellen Lernens MLM verwendet werden.

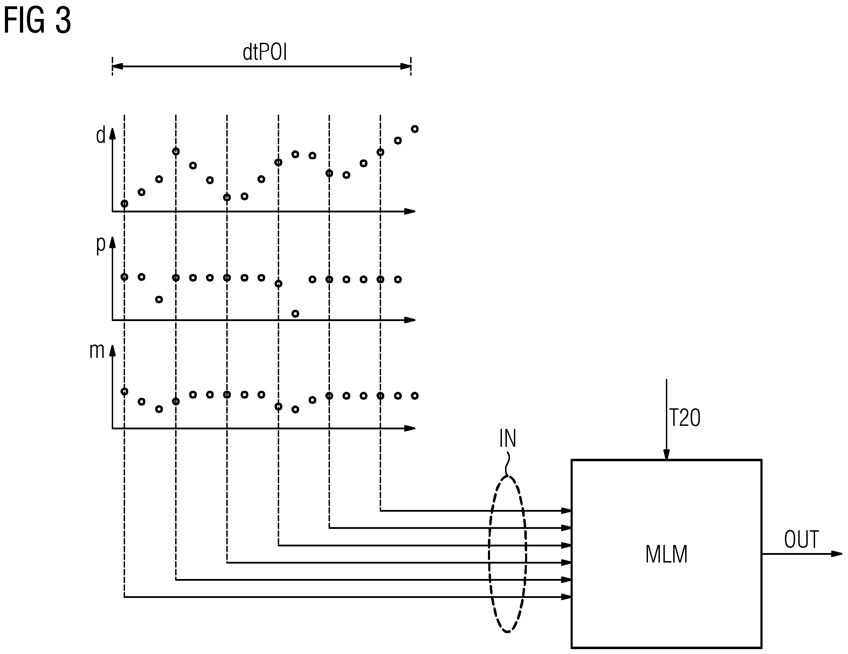

FIG 3 zeigt nun die Eingangsgrößen IN, die wie in FIG 2 gezeigt zur Verfügung gestellt wurden und erläutert weiterhin, wie die für den Abschnitt dtPOI des Weges x als Eingangsgrö-ßen IN für das trainierte Modell des maschinellen Lernens MLM zur Verfügung gestellt werden. Der Übersichtlichkeit halber wird im vorliegenden Fall nur jeder dritte Datenpunkt in das Modell MLM geführt. In der Regel sollte aber bei einer auf das Modell MLM angepassten Diskretisierung der Eingangsgrößen IN jeder Datenpunkt in das Modell MLM geführt werden. Das Modell MLM erhält weiterhin als Eingangsgröße eine Hintergrundtemperatur T20, die beispielsweise aus einer übergeordneten thermischen Simulation stammen kann. Als Ausgangsgröße OUT liefert das Modell MLM ein Maß für das Prozessleuchten E10, also beispielsweise die Strahlungsintensität, die Wellenlänge oder eine für die weitere Verarbeitung optimierte dimensionslose Größe, beispielsweise eine Größe, die analog zu einem Sensorwert einer Messung einer der Strahlungsintensitäten und/oder Wellenlängen zur Verfügung steht.

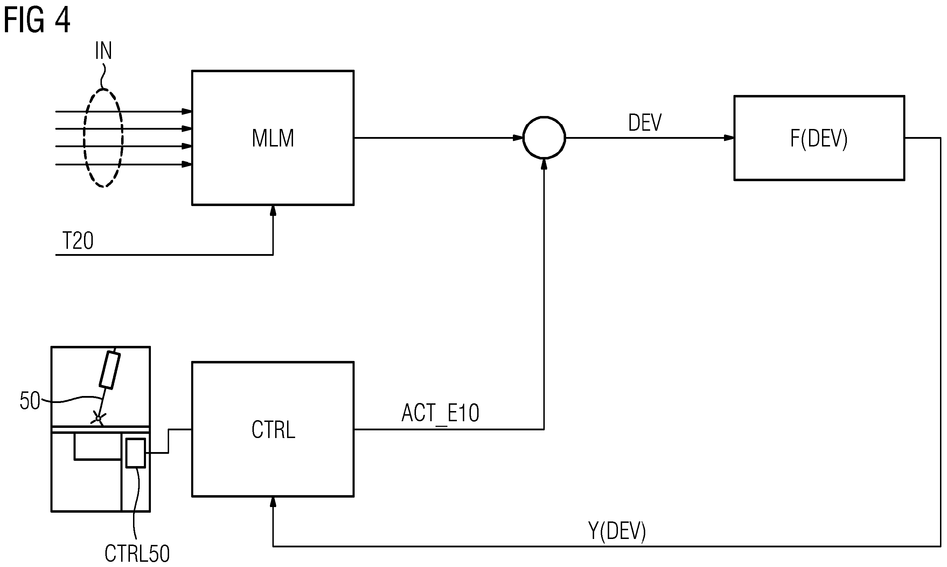

FIG 4 zeigt eine Ausführungsform, in der Prozessabweichungen DEV eines Schmelzprozesses mittels des Modells des maschinellen Lernens MLM, das z. B. aus FIG 3 bekannt ist, ermittelt werden. In das Modell fließen dabei die Eingangsgrößen IN sowie die Hintergrundtemperatur T20 ein. Das trainierte Modell des maschinellen Lernens MLM erzeugt auf Basis dieser Daten einen Wert für das Prozessleuchten E10 und erzeugt damit einen Sollwert SET E10 für das Prozessleuchten. Auf Basis des Sollwerts SET E10 und eines Istwerts des Prozessleuchtens ACT_E10 wird eine Prozessabweichung DEV des Schmelzprozesses festgestellt. Der Istwert ACT_E10 kann dabei beispielsweise von einer Steuerung CTRL einer Energiestrahlanlage 100 zur Verfügung gestellt werden. Die Energiestrahlanlage 100 ist dabei schematisch gezeigt und weist einen Energiestrahl 50 sowie eine Energiestrahlsteuerung CTRL50 auf. Die Steuerung der Energiestrahlanlage CTRL kann dabei neben der Energiestrahlleistung auch weitere Größen und Prozessparameter als Eingangsgrößen IN zur Verfügung stellen. Es ist ebenso denkbar, dass die Eingangsgrößen IN von einer weiteren Verarbeitungseinheit, die in die Steuerung CTRL integriert ist oder separat davon zur Verfügung gestellt wird, zur Verfügung stellt. Die Prozessabweichung DEV wird mit einer Regelungsfunktion F(DEV) in eine Stellgröße Y(DEV) gewandelt. Die Stellgröße Y(DEV) kann dabei der Steuerung der Energiestrahlanlage zur Verfügung gestellt werden. Die Stellgröße Y(DEV) kann dabei beispielsweise eine neue Laserstrahlleistung, ein neues Timing zwischen den Vektoren, eine veränderte Strahlgeschwindigkeit, ein veränderter Hatchabstand, etc. sein.

Zusammenfassend betrifft die Erfindung ein Verfahren zum Ermitteln einer Strahlungsintensität und/oder einer Wellenlänge eines Prozessleuchtens E10, ein Verfahren zum Ermitteln von Prozessabweichungen DEV eines Schmelzprozesses Um die Ermittlung einer Strahlungsintensität und/oder einer Wellenlänge eines Prozessleuchtens eines Schmelzprozesses zu verbessern wird vorgeschlagen ein Leistungsprofils P für einen Abschnitt dtPOI des Weges x als eine Eingangsgröße IN für ein Modell des maschinellen Lernens MLM bereitzustellen, insbesondere für ein neuronales Netz, wobei das Modell MLM mit historischen Leistungsprofilen PH und zugehörigen historischen Strahlungsintensitäten E10H und/oder Wellenlängen des Prozessleuchtens E10 trainiert ist, und daraus die Strahlungsintensität und/oder die Wellenlänge des Prozessleuchtens E10 als Ausgangsgröße OUT des Modells MLM zu ermitteln.

### Bezugszeichenliste

- 10: Schmelzbad
- E10: Prozessleuchten des Schmelzbads
- 20: Werkstoff
- 30: Pulverförmiger Werkstoff
- 50: Energiestrahl
- 100: Energiestrahlanlage

- x: Weg
- POI: Position
- POI': Beginn des Abschnitts
- dtPOI: Abschnitt

- p: Leistungsprofil im Abschnitt
- d: Abstandshistorie im Abschnitt
- m: Massenprofil im Abschnitt

- MLM: Modell des maschinellen Lernens
- IN: Eingangsgröße des Modells
- OUT: Ausgabe des Modells
- T20: Hintergrundtemperatur als Eingangsgröße des Modells

- DEV: Prozessabweichungen des Schmelzprozesses
- SET_E10: Sollwert für das Prozessleuchten
- ACT_E10: Istwert des Prozessleuchtens
- F(DEV): Regelungsfunktion
- Y(DEV): Stellgröße
- CTRL: Steuerung der Energiestrahlanlage
- CTRL50: Steuerung des Energiestrahls

## Patentansprüche

1. Verfahren zum Ermitteln von Prozessabweichungen (DEV) eines Schmelzprozesses beim Erzeugen eines Werkstücks oder beim Fügen von Werkstücken, umfassend die Schritte:
- Bereitstellen eines Sollwerts (SET_E10) für ein Prozessleuchten (E10) eines Schmelzbads (10),
- Erfassen einer vom Schmelzbad (10) emittierten Strahlungsintensität und/oder einer Wellenlänge des Prozessleuchtens (E10) als Istwert (ACT_E10) und
- Vergleichen des Sollwerts (SET_E10) mit dem Istwert (ACT_I10), um Prozessabweichungen (DEV) zu detektieren,
wobei der Sollwert (SET_E10) durch eine Strahlungsintensität und/oder eine Wellenlänge des Prozessleuchtens (E10) festgelegt wird, welche Strahlungsintensität und/oder Wellenlänge des Prozessleuchtens (E10) mittels eines Ermittlungsverfahrens ermittelt wird,
wobei das Prozessleuchten Emission im sichtbaren und nahen Infrarotbereich umfasst und wobei das dem Prozessleuchten (E10) zugrundeliegendes Schmelzbad (10) durch ein Bestrahlen eines metallischen Werkstoffs (20) mit einem Energiestrahl (50) entlang wenigstens eines Weges (x) erzeugbar ist,
wobei der Energiestrahl (50) ein Laserstrahl ist,
wobei der Energiestrahl (50) gemäß einem Leistungsprofil (P) entlang des Weges (x) bewegbar ist, umfassend die Ermittlungsverfahrensschritte:
- Bereitstellen des Leistungsprofils (P) für einen Abschnitt (dtPOI) des Weges (x) als eine Eingangsgröße (IN) für ein Modell des maschinellen Lernens (MLM), insbesondere für ein neuronales Netz,
wobei das Modell (MLM) mit historischen Leistungsprofilen (PH) und zugehörigen historischen Strahlungsintensitäten (E10H) und/oder Wellenlängen des Prozessleuchtens (E10) aus vorhergehenden Messreihen trainiert ist, und wobei das Modell (MLM) eine Topologie mit Regressionskoeffizienten aufweist, und
- Ermitteln der Strahlungsintensität und/oder der Wellenlänge des Prozessleuchtens (E10) als Ausgangsgröße (OUT) des Modells (MLM).

2. Verfahren nach Anspruch 1, umfassend den Ermittlungsverfahrensschritt:
- Bereitstellen zumindest einer Abstandshistorie (d) für den Abschnitt (dtPOI) als Eingangsgröße für das Modell (MLM), wobei die Abstandshistorie (d) den Abstand zwischen dem jeweiligen Datenpunkt auf dem Abschnitt und der Position beschreibt, an der die Strahlungsintensität und/oder die Wellenlänge des Prozessleuchtens ermittelt werden soll und als Funktion der Zeit ausgebildet ist.

3. Verfahren nach Anspruch 1 oder 2, umfassend den Ermittlungsverfahrensschritt:
- Bereitstellen zumindest eines Massenprofils (m) für den Abschnitt (dtPOI) als Eingangsgröße für das Modell (MLM).

4. Verfahren nach einem der vorhergehenden Ansprüche, umfassend den Ermittlungsverfahrensschritt:
- Bereitstellen zumindest einer Temperatur, die der Werkstoff aufweist, (T20) als Eingangsgröße für das Modell (MLM).

5. Verfahren nach einem der vorhergehenden Ansprüche, wobei der Abschnitt (xPOS) so gewählt ist, dass zumindest eine Unterbrechung des Energiestrahls (50) umfasst ist.

6. Verfahren nach einem der vorhergehenden Ansprüche, wobei der Abschnitt (xPOS) abhängig von einer Werkstückgeometrie gewählt wird.

7. Verfahren nach einem der vorhergehenden Ansprüche, wobei die Relevanz der Prozessabweichung anhand von Klassifikationsparametern gewichtet wird.

## Claims

1. Method for determining process deviations (DEV) of a melting process when generating a workpiece or when joining workpieces, comprising the steps:
- providing a target value (SET_E10) for a process light (E10) of a melt pool (10),
- detecting a radiation intensity, which is emitted by the melt pool (10), and/or a wavelength of the process light (E10) as an actual value (ACT_E10) and
- comparing the target value (SET_E10) with the actual value (ACT_I10), in order to detect process deviations (DEV),
wherein the target value (SET_E10) is determined by a radiation intensity and/or a wavelength of the process light (E10), which radiation intensity and/or wavelength of the process light (E10) is determined by means of a determination method,
wherein the process light comprises emission in visible and near infrared light and wherein the melt pool (10) underlying the process light (E10) can be generated by irradiating a metal material (20) with an energy beam (50) along at least one path (x),
wherein the energy beam (50) is a laser beam,
wherein the energy beam (50) can be moved in accordance with a power profile (P) along the path (x), comprising the determination method steps:
- providing the power profile (P) for a section (dtPOI) of the path (x) as an input variable (IN) for a machine learning model (MLM), in particular for a neural network,
wherein the model (MLM) is trained using historical power profiles (PH) and associated historical radiation intensities (E10H) and/or wavelengths of the process light (E10) from previous measurement series and wherein the model (MLM) has a topology having coefficients of regression,
and
- determining the radiation intensity and/or the wavelength of the process light (E10) as an output variable (OUT) of the model (MLM).

2. Method according to claim 1, comprising the determination method step:
- providing as an input variable for the model (MLM) at least one distance history (d) for the section (dtPOI), wherein the distance history (d) describes the distance between the respective data point on the section and the position at which the radiation intensity and/or the wavelength of the process light is to be determined and the distance history is designed as a function of time.

3. Method according to claim 1 or 2, comprising the determination method step:
- providing as an input variable for the model (MLM) at least one mass profile (m) for the section (dtPOI).

4. Method according to one of the preceding claims, comprising the determination method step:
- providing as an input variable for the model (MLM) at least one temperature (T20) which the workpiece has.

5. Method according to one of the preceding claims, wherein the section (xPOS) is selected so that at least one interruption of the energy beam (50) is included.

6. Method according to one of the preceding claims, wherein the section (xPOS) is selected in dependence upon a workpiece geometry.

7. Method according to one of the preceding claims, wherein the relevance of the process deviation is weighted with the aid of classification parameters.

## Revendications

1. Procédé de détermination d'écarts (DEV) d'un processus de fusion lors de la production d'une pièce ou lors de la jonction de pièces, comprenant les stades :
- on se procure une valeur (SET_E10) de consigne d'une luminescence (E10) de processus d'un bain (10) de fusion,
- on détecte l'intensité du rayonnement émis par le bain (10) de fusion et/ou la longueur d'onde de la luminescence (E10) de processus comme valeur (ACT_E10) réelle et
- on compare la valeur (SET_E10) de consigne à la valeur (ACT_I10) réelle afin de détecter des écarts (DEV) de processus,
dans lequel on fixe la valeur (SET_E10) de consigne par une intensité du rayonnement et/ou une longueur d'onde de la luminescence (E10) de processus, laquelle intensité du rayonnement et/ou longueur d'onde de la luminescence (E10) du processus est déterminée au moyen d'un procédé de détermination,
dans lequel la luminescence de processus comprend une émission dans le domaine visible et dans le domaine du proche infrarouge et dans lequel le bain (10) de fusion à la base de la luminescence (E10) de processus peut être produit, en exposant un matériau (20) métallique à un faisceau (50) d'énergie le long d'au moins un chemin (x),
dans lequel le faisceau (50) d'énergie est un faisceau laser,
dans lequel le faisceau (50) d'énergie peut être déplacé le long du chemin (x) suivant un profil (P) de puissance, comprenant les stades de procédé de détermination :
- on se procure le profil (P) de puissance pour un tronçon (dtPOI) du chemin (x) comme grandeur (IN) d'entrée pour un modèle de l'apprentissage (MLM) automatique, en particulier pour un réseau neuronal,
dans lequel on fait l'apprentissage du modèle (MLM) par des profils (PH) de puissance historiques et des intensités (E10H) de rayonnement historiques leur appartenant et/ou des longueurs d'onde de la luminescence (E10) de processus à partir de séries de mesure précédentes, et dans lequel le modèle (MLM) a une topologie à coefficients de régression, et
- on détermine l'intensité du rayonnement et/ou la longueur d'onde de la luminescence (E10) de processus comme grandeur (OUT) de sortie du modèle (MLM).

2. Procédé suivant la revendication 1, comprenant les stades de procédé de détermination :
- on se procure au moins un historique (d) de distance pour le tronçon (dtPOI) comme grandeur d'entrée du modèle (MLM), dans lequel l'historique (d) de distance décrit la distance entre le point de date respectif sur le tronçon et la position, où l'intensité du rayonnement et/ou la longueur d'onde de la luminescence du processus doit être déterminée, et est constitué en fonction du temps.

3. Procédé suivant la revendication 1 ou 2, comprenant le stade de procédé de détermination :
- on se procure au moins un profil (m) de masse pour le tronçon (dtPOI) comme grandeur d'entrée pour le modèle (MLM).

4. Procédé suivant l'une des revendications précédentes, comprenant le stade de procédé de détermination :
- on se procure au moins une température (T20) qu'a le matériau comme grandeur d'entrée pour le modèle (MLM).

5. Procédé suivant l'une des revendications précédentes, dans lequel le tronçon (xPOS) est choisi, de manière à comprendre au moins une interruption du faisceau (50) d'énergie.

6. Procédé suivant l'une des revendications précédentes, dans lequel on choisit le tronçon (xPOS) en fonction d'une géométrie de la pièce.

7. Procédé suivant l'une des revendications précédentes, dans lequel on pondère la pertinence de l'écart de processus à l'aide de paramètres de classification.
